# EUROPÄISCHE PATENTSCHRIFT

(11) **EP 1 544 911 B1**
(45) Veröffentlichungstag und Bekanntmachung des Hinweises auf die Patenterteilung: **25.07.2007**
(21) Anmeldenummer: 04028528.0
(22) Anmeldetag: 02.12.2004
(51) Int. Cl.: H01L 21/68, G03F 7/20

(54) **Justiervorrichtung**
Adjusting device
Dispositif d'ajustage

(30) Priorität: 17.12.2003 DE 10359273
(43) Veröffentlichungstag der Anmeldung: 22.06.2005
(73) Patentinhaber: Thallner, Erich, Dipl.-Ing., 4782 St. Florian (AT)
(72) Erfinder: Thallner, Erich, Dipl.-Ing., 4782 St. Florian (AT)
(74) Vertreter: Becker, Thomas

(56) Entgegenhaltungen:
- EP-A- 0 437 741
- EP-A- 0 469 956
- DE-A1- 3 740 561
- DE-A1- 10 011 512
- US-A- 5 040 431
- PATENT ABSTRACTS OF JAPAN Bd. 011, Nr. 128 (M-583), 22. April 1987 (1987-04-22) -& JP 61 270044 A (TOSHIBA CORP), 29. November 1986 (1986-11-29)

## Beschreibung

Die Erfindung betrifft eine Justiervorrichtung zur Ausrichtung eines Gegenstandes in einer Ebene.

Beispielsweise bei der Erstellung von elektrischen Strukturen (Schaltungen) auf Halbleiterscheiben (Wafern) mittels lithographischer Verfahren ist es notwendig, den Wafer gegenüber einer Maske in einer horizontalen Ebene exakt zu positionieren. Eine entsprechende Problematik ergibt sich auch im Bereich weiterer verfahrenstechnischer Stufen bei der Herstellung, Bearbeitung oder Verarbeitung von Wafern.

Der Stand der Technik und die Erfindung werden nachstehend anhand der Justierung eines Wafers auf/in einer Aufnahme näher beschrieben. Die Erfindung ist insoweit jedoch nicht auf diesen Anwendungsbereich beschränkt, sondern dient der Ausrichtung beliebiger Gegenstände.

Während die Ausrichtung des Wafers in x- und y-Richtung innerhalb einer Ebene beispielsweise mit einem Mikroskop überwacht werden kann, bereitet es erhebliche konstruktive Probleme, den Wafer auf einem entsprechenden Aufnahmeteil zu konfektionieren, der die gewünschte Beweglichkeit in x- und y-Richtung sowie eine sichere Fixierung der jeweiligen Endposition gewährleistet.

Die EP 04 699 56 A offenbart eine Justiervorrichtung, bei der Seile in unterschiedlichen Höhen über einen Tisch an deren Aufnahmeteil angeordnet sind. Es wäre nicht naheliegend die aus EP 04 699 56 A bekannten Seile über Gelenke an der Aufnahme anzulenken da dies, ohne weiteren Änderungen der Aufnahme, zu Beeinträchtigungen der Bewegungsfreiheit der Seile führen würde. Die EP 04 377 41 A offenbart dagegen eine Justiervorrichtung mit starren Zugorganen. Die US 5,040,431 A zeigt eine Justiervorrichtung mit einer Einrichtung zur ortsfesten Positionierung einer Aufnahme auf einem Tisch. In der JP 61 27 00 44 A wird eine Justierung eines Aufnahmeteils durch Umsetzung translatorischer Bewegungen über elastische Scharniere gezeigt. Es wäre nicht naheliegend die aus JP 61 2700 44 A bekannten Zugorganen durch Seile zu ersetzen da hierdurch z.B. die für Translationsbewegungen entlang der x-Achse benötigten Kraftkomponenten senkrecht zur Längenrichtung der Zugorgane nicht erzeugt werden können.

Die DE 101 28 713 A1 beschreibt einen Justiertisch der vorgenannten Art mit einem äußeren Rahmen, einem Zwischenrahmen, welcher in einer ersten Richtung relativ zum äußeren Rahmen bewegbar ist, und einem Aufnahmeteil für den zu justierenden Gegenstand, wobei dieser Aufnahmeteil wiederum in einer weiteren Richtung innerhalb des Zwischenrahmens verschiebbar angeordnet wird. Mechanische Verstelleinrichtungen ermöglichen die Verschiebbarkeit der genannten Teile zueinander und deren anschließende Fixierung in einer gewünschten Position. Die Verstellwege sind stark limitiert.

Dieser Justiertisch hat sich grundsätzlich bewährt. Mit der Erfindung soll eine alternative konstruktive Gestaltung vorgestellt werden. Ein Nebenaspekt ist, eine exakte Justierbarkeit auch dann zu gewährleisten, wenn bei weiteren Verfahrensschritten beispielsweise Druck auf den zu justierenden Gegenstand ausgeübt wird. Dies ist zum Beispiel dann der Fall, wenn der Gegenstand (zum Beispiel ein Wafer, thermisch verformbarer Kunststoff oder eine Folie) geprägt wird.

Der Erfindung liegt die Erkenntnis zugrunde, dass es auch für eine exakte und äußerst präzise Justierung (mit Toleranzen im µm-Bereich und darunter) nicht unbedingt notwendig ist, ein mehr oder weniger "starres" Justiersystem bereitzustellen. Das gewünschte Ziel lässt sich auch nach Art einer "schwimmenden" Justierung erreichen, sofern insbesondere folgende Anforderungen erfüllt werden:

Es müssen sich sehr kleine Verschiebewege beispielsweise in x- und y-Richtung sowie entsprechende Winkelverschiebungen realisieren lassen.

Die Justiereinheit muss nach Erreichen der gewünschten Justierposition exakt definierbar sein.

Grundgedanke der Erfindung ist es, den zu justierenden Gegenstand in oder auf einer Aufnahme lösbar zu fixieren, wobei diese Aufnahme entlang eines zugehörigen Tisches in die gewünschte Position gebracht werden kann, und zwar mittels Seilen. Unabhängig von der Größe und Form der Aufnahme sind dabei mindestens drei Seile notwendig, um die gewünschte x-, y- und Winkelverschiebung realisieren zu können.

Werden die drei Seile beispielsweise an den Ecken eines gedachten, beispielsweise gleichwinkligen Dreiecks angeordnet, oder bei vier Seilen im Bereich der Ecken eines Rechteckes (insbesondere eines Quadrates) oder eines Trapezes, so lässt sich der jeweilige Gegenstand bezüglich aller genannten Freiheitsgrade exakt ausrichten.

Danach betrifft die Erfindung in ihrer allgemeinsten Ausführungsform eine Justiervorrichtung gemäß Patentanspruch 1.

Soweit die Aufnahme auf dem Tisch positionierbar sein soll bedeutet dies, dass die Aufnahme im Wesentlichen parallel zur Tischoberfläche in beliebigen Richtungen verschiebbar ist. Dabei kann der Tisch horizontal ausgerichtet sein. Der Tisch kann aber auch schräg zur Horizontalen verlaufen, bis hin zu einer vertikalen Position.

Die endgültige Position der Aufnahme, relativ zum Tisch, wird über die genannten Seile eingestellt und kann dann zusätzlich fixiert werden, wie noch erläutert wird.

Der zu justierende Gegenstand wird lösbar in der Aufnahme fixiert. Dies kann zum Beispiel mechanisch durch Klemmung, Verrastung oder dergleichen erfolgen. Eine andere Möglichkeit besteht darin, den Gegenstand an oder in der Aufnahme durch Unterdruck festzusaugen. Soweit die Seile an der Aufnahme angelenkt sind bedeutet dies, dass bei Zugbelastung eines Seils eine Zugkraft auf die Aufnahme erfolgt und damit eine Richtungsverschiebung. Entsprechend werden gleichzeitig andere Seile mitgeführt oder nachgeführt, um die gewünschte Verschiebung der Aufnahme (und parallel dazu des Gegenstandes) zu ermöglichen.

Geht man davon aus, dass die Aufnahme auf einem horizontalen Tisch verschiebbar angeordnet ist so ergibt sich bereits dann, wenn man nur eine Verschieberichtung (beispielsweise x-Richtung) betrachtet, dass die Seile in entgegengesetzter Richtung wirken müssen, um die Aufnahme beispielsweise nach rechts oder links verschieben zu können. Das Merkmal, gemäß dem die Seile in mindestens zwei unterschiedlichen Richtungen wirken sollen, bedeutet dabei nicht zwangsläufig entgegengesetzte Richtungen. Vielmehr ergibt sich daraus die grundsätzliche Orientierung der Seile. Dabei können bereits zwei Seile, die an unterschiedlichen Abschnitten der Aufnahme angreifen, und beispielsweise winkelmäßig versetzt zueinander sind, nicht nur eine Verschiebung nach rechts oder links (oder: oben und unten) bewirken, sondern gleichzeitig auch zu einer Winkelverschiebung der Aufnahme relativ zum Tisch führen. Auch dies wird nachstehend näher erläutert.

Insbesondere um die gewünschte Winkelverschiebung zu ermöglichen sieht eine Ausführungsform der Erfindung vor, dass die Seile an der Aufnahme gelenkig, aber ortsfest angeordnet sind. Der Anlenkpunkt ist dabei fixiert. Die Orientierung des Seils gegenüber der Aufnahme (beispielsweise der Winkel zwischen Seil und korrespondierender Kante der Aufnahme) kann sich jedoch verändern. Eine Einrichtung zum Auf- und Abwickeln des Seils wird im Abstand zur Anlenkstelle angeordnet.

Die Seile können zwischen ihren Enden über Umlenkrollen geführt werden. Sie können dabei auch durch den Tisch hindurch unter den Tisch geführt werden, wo beispielsweise Motoren angeordnet sind, über die die Seile aktivierbar sind.

Wie bereits ausgeführt sind die ersten Enden der Seile an gegenüberliegenden Abschnitten der Aufnahme angelenkt. Bei einer in der Aufsicht quadratischen Aufnahme können beispielsweise zwei Seile entlang einer Seitenkante, beispielsweise jeweils am Ende, und ein drittes Seil in der Mitte der gegenüberliegenden Kante angeordnet werden.

Die Anlenkbereiche der Seile sind beispielsweise im Umfangsbereich der Aufnahme.

Je größer der Abstand der Anlenkstellen der Seile zueinander ist um so größer sind die Verstellmöglichkeiten zur Positionierung der Aufnahme (des Gegenstandes). Nach einer Ausführungsform weisen die ersten Enden der Seile entsprechend einen maximalen Abstand voneinander auf.

Bei drei Seilen können die Anlenkstellen die Ecken eines gedachten Dreiecks bilden. Bei vier Seilen können die gedachten Verbindungslinien zwischen den Anlenkbereichen (den ersten Enden) ein Rechteck, beispielsweise ein Quadrat beschreiben, aber auch ein Trapez.

Bei vier können zwei Seile spiegelbildlich zu zwei weiteren Seilen angeordnet werden. Diese Ausführungsform wird in der nachstehenden Figurenbeschreibung näher erläutert. Auf diese Weise werden ausgezeichnete Verstellmöglichkeiten mit extrem kurzen Verstellwegen erreicht.

Der Begriff Seil schließt Drähte, Bänder und Fäden ein.

Weist der Tisch eine Kalibriereinrichtung, beispielsweise eine Rasterung auf, lässt sich die Position der Aufnahme unmittelbar ermitteln.

Ebenso kann eine unabhängige Messeinrichtung vorgesehen werden, die zur direkten Ermittlung der Position der Aufnahme auf dem Tisch dient. Dies ist beispielsweise eine optische Messeinheit, wie eine Kamera, ein Mikroskop oder der dergleichen.

Nach einer weiteren Ausführungsform ist jeweils eine Messeinrichtung zur Ermittlung der Position oder Länge jedes ersten Endes der Seile vorgesehen.

Gleichzeitig wird über eine Auswerteeinheit (einen Rechner) aus den entsprechenden Koordinaten die Position der Aufnahme auf dem Tisch berechnet. Solche Messeinrichtungen können Sender/Empfänger umfassen, wobei jeweils eine Sender-/Empfängereinheit einem Seil zugeordnet sein kann.

Bereits eingangs wurde erwähnt, dass nach der Justierung der Aufnahme auf dem Tisch die Aufnahme vorzugsweise ortsfest fixiert (positioniert) wird. Dies ist beispielsweise wichtig, wenn der zu justierende Gegenstand anschließend druckbelastet wird, zum Beispiel durch Prägung. Es wird dann sichergestellt, dass auch während des Prägevorgangs die Position der Aufnahme und damit des Gegenstandes nicht verändert wird.

Die Einrichtung kann beispielsweise eine Einrichtung zum Festsaugen der Aufnahme auf dem Tisch sein.

Eine entsprechende Saugeinheit kann auch zur (temporären) Festlegung des Gegenstandes auf oder in der Aufnahme dienen. Zum Wechseln des Gegenstandes wird das Vakuum einfach unterbrochen.

Um eine möglichst reibungs- und damit störungsfreie Beweglichkeit der Aufnahme auf dem Tisch zu ermöglichen können zwischen Aufnahme und Tisch Gleitmittel vorgesehen werden. Dies können flüssige oder viskose Gleitmittel sein. Ebenso sind aber auch mechanische Gleitmittel, wie Kugelrollen etc. oder die Ausbildung eines Luftlagers möglich. Der Begriff "Luftlager" umfasst beispielsweise Ausführungsformen, die vom "Bernoulli-Effekt" Gebrauch machen, bei denen ein Luftpolster zwischen Tisch und Aufnahme ausgebildet wird.

Sofern von einer Bewegung der Aufnahme "auf dem Tisch" vorstehend gesprochen wurde bedeutet dies demnach nicht zwangsweise, dass die Aufnahme unmittelbar auf der Oberfläche des Tisches aufliegt; die Aufnahme wird jedoch parallel zur Tischoberfläche verschoben.

Das genannte Luftpolster (Luftlager) kann unterbrochen und die Aufnahme auf den Tisch angesaugt werden, wenn die endgültige Justierposition erreicht ist.

Weitere Merkmale der Erfindung ergeben sich aus den Merkmalen der Unteransprüche sowie den sonstigen Anmeldungsunterlagen.

Die Erfindung wird nachstehend anhand eines Ausführungsbeispieles näher erläutert.

Dabei zeigen - jeweils in schematisierter Darstellung - :

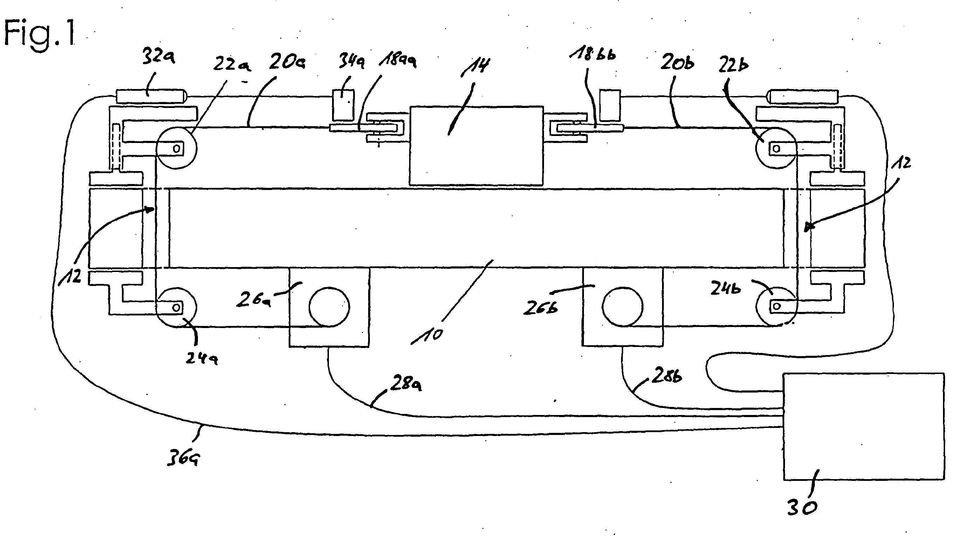

- Figur 1:: Eine teilweise weggeschnittene Seitenansicht einer erfindungsgemäßen Justiervorrichtung,

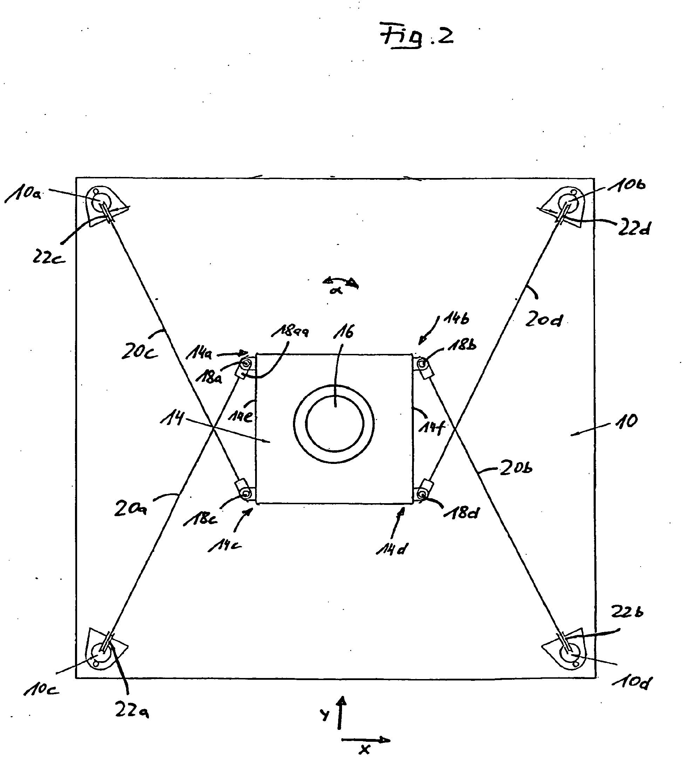

- Figur 2:: Eine Aufsicht auf die Justiervorrichtung nach Figur 1.

Die Vorrichtung umfasst einen Tisch 10, der hier eine quadratische Grundfläche mit entsprechend vier Eckbereichen 10a-d aufweist. In den Eckbereichen 10a-d verläuft jeweils eine Bohrung 12 durch den Tisch. Etwa mittig liegt auf dem Tisch eine Aufnahme 14, die eine Quaderform mit quadratischem Grundriss aufweist und deren vier Ecken mit 14a-d gekennzeichnet sind.

In einer Vertiefung der Aufnahme 14 liegt ein zu positionierender Wafer 16.

In den Ecken 14a-d sind an gegenüberliegenden Kanten 14e, f der Aufnahme 14 Gelenke 18a-d angeordnet, die entlang einer Ebene parallel zum Tisch 10 verschwenkbar sind.

Vom Gelenk 18a erstreckt sich ein Gelenkarm 18aa, von dem aus ein Seil 20a in Richtung auf die Ecke 10c de Tisches 10 verläuft, wo das Seil 20a um eine Umlenkrolle 22a durch die zugehörige Öffnung 12 unter den Tisch 10 geführt wird, wo es um eine weitere Umlenkrolle 24a zu einer Antriebseinheit 26a geführt wird, in der das Seil 22a motorisch auf- beziehungsweise abgewickelt werden kann. Von der Antriebseinheit 26a verläuft eine Leitung 28a zu einem Rechner 30.

Entsprechend erstreckt sich ein Seil 20b von einem Gelenkarm 18bb in Richtung auf die Ecke 10d und verläuft über Umlenkrollen 22b, 24b zu einer Antriebseinheit 26b, von der wiederum eine Leitung 28b zum Rechner 30 verläuft.

Auf gleiche Weise erstrecken sich von den Anlenkstellen 18c, 18d Seile 20c, 20d in Richtung auf die gegenüberliegenden Ecken 10a, 10b des Tisches 10 und dort wiederum über Umlenkrollen 22c, 22d durch die Öffnungen 12 unter den Tisch zu entsprechenden Antriebseinheiten (nicht dargestellt), von denen wiederum Verbindungsleitungen (ebenfalls nicht dargestellt) zum Rechner 30 verlaufen.

In der dargestellten Ausgangsposition sind die Seile 20a-d gespannt. Wie zu erkennen ist verlaufen die Seile 20a, 20b in unterschiedlicher Richtung (im Wesentlichen entgegengesetzt) zu den Seilen 20c, 20d. Anders ausgedrückt: Der Verlauf der Seile 20a, 20b ist im Wesentlichen spiegelbildlich zum Verlauf der Seile 20c, 20d.

Das System ist in sich stabil. Die Position der Aufnahme 14 relativ zum Tisch 10 lässt sich jedoch verstellen, und damit der Wafer 16 in gewünschter Weise positionieren, wenn nunmehr die Antriebseinheiten (wie 26a, 26b) aktiviert werden und dabei die entsprechenden Seile 20a-d verkürzt beziehungsweise verlängert (nachgeführt) werden. Zum Beispiel durch Zug auf die Seile 20c, 20b lässt sich die Aufnahme 14 sowohl in x- wie y-Richtung verschieben. Gleichzeitig kommt es zu einer Winkelverschiebung, welche durch den Pfeil α dargestellt ist. Die Seile 20a, 20d werden über den Rechner 30 und die zugehörigen Antriebseinheiten nachgeführt.

Zur Bestimmung der exakten jeweiligen Position der Aufnahme 14 ist ein Entfernungsmesssystem vorgesehen, welches auf Laserbasis arbeitet. Dabei ist jeweils ein solches Messsystem jedem Seil 20a-d zugeordnet und wird nachstehend beispielhaft für das Seil 20a erläutert.

Im Eckbereich 10c oberhalb der Umlenkrolle 22a ist ein Sender 32a angeordnet, der einen Laserstrahl auf einen Empfänger 34a sendet, der oberhalb des Gelenkarms 18aa angeordnet ist. Mit Hilfe dieser Messeinrichtung lässt sich die Länge des Seils 20a zwischen Sender 32a und Empfänger 34a exakt bestimmen. Der Sender 32a ist ortsfest, aber verschwenkbar (drehbar) angeordnet. Der Empfänger 34a verändert seine Position entsprechend der Verstellung der Aufnahme 14. Die Messeinrichtung ist über ein Leitung 36a ebenfalls mit dem Rechner 30 verbunden.

Aus den Messdaten, die alle vier Messeinrichtungen (für jedes Seil 20a-d) liefern lässt sich auf diese Weise die exakte Ausrichtung der Aufnahme 14 und damit des Wafers 16 berechnen, und zwar laufend, während der Verstellung (Justierung) und in der endgültigen Endposition.

Alternativ könnte oberhalb der Aufnahme 14 eine optische Messeinrichtung angeordnet werden, die die exakte Position der Aufnahme 14 auf dem Tisch 10 angibt.

Der Tisch 10 kann unterhalb der Aufnahme 14 mit einer Vielzahl von kapillaren Bohrungen versehen sein, die an eine Unterdruckquelle anschließbar sind, um die Aufnahme 14 nach Erreichen der gewünschten Endposition ortsfest gegen den Tisch ansaugen zu können.

Während der Positionierung der Aufnahme 14 kann zwischen der Aufnahme 14 und dem Tisch 10 ein Luftpolster ausgebildet werden, beispielsweise nach Art des sogenannten "Bernoulli-Effekts", wobei die selben Kapillaren benutzt werden können.

## Patentansprüche

1. Justiervorrichtung zur Ausrichtung eines Gegenstandes (16) in einer Ebene, mit folgenden Merkmalen:
1.1 Einem Tisch (10),
1.2 einer auf dem Tisch (10) positionierbaren Aufnahme (14), wobei
1.3 die Aufnahme (14) zur lösbaren Fixierung des zu positionierenden Gegenstandes (16) ausgebildet ist,
1.4 mindestens drei Seilen (20a-d), die jeweils über Gelenke (18a-d, 18aa, 18bb), die zwischen den ersten Enden der Seile (20a-d) und der Aufnahme (14) angeordnet sind und die entlang einer Ebene parallel zum Tisch (10) verschwenkbar sind, mit einem ersten Ende an gegenüberliegenden Abschnitten (14e, f) der Aufnahme (14) und mit einem zweiten Ende an Tisch (10) angelenkt sind, wobei
1.5 die Seile (20a-d) in mindestens zwei unterschiedlichen Richtungen (x, y, α) wirken.

2. Justiervorrichtung nach Anspruch 1, bei der die Seile (20a-d) an der Aufnahme (14) gelenkig (18a-d), aber ortsfest angeordnet sind.

3. Justiervorrichtung nach Anspruch 1, bei der die Seile (20a-d) zwischen ihren Enden über Umlenkrollen (22a-d) geführt sind.

4. Justiervorrichtung nach Anspruch 1, bei der die ersten Enden der Seile (20a-d) im Umfangsbereich der Aufnahme (14) angeordnet sind.

5. Justiervorrichtung nach Anspruch 1, bei der die ersten Enden der Seile (20a-d) einen maximalen Abstand zueinander aufweisen.

6. Justiervorrichtung nach Anspruch 1 mit drei Seilen, wobei gedachte Verbindungslinien zwischen ihren ersten Enden ein Dreieck beschreiben.

7. Justiervorrichtung nach Anspruch 1 mit vier Seilen (20a-d), wobei gedachte Verbindungslinien zwischen ihren ersten Enden ein Rechteck beschreiben.

8. Justiervorrichtung nach Anspruch 7, bei dem je zwei Seile (20a, b) spiegelbildlich zu zwei weiteren Seilen (20c, d) angeordnet sind.

9. Justiervorrichtung nach Anspruch 7, wobei die gedachten Verbindungslinien ein Quadrat beschreiben.

10. Justiervorrichtung nach Anspruch 1 mit jeweils einer Messeinrichtung (32a, 34a) zur Ermittlung der Position jedes ersten Endes der Seile (20a-d) und einer Auswerteeinheit (30) zur Bestimmung der Position der Aufnahme (14) auf dem Tisch (10).

11. Justiervorrichtung nach Anspruch 1 mit einer Messeinrichtung zur direkten Ermittlung der Position der Aufnahme (14) auf dem Tisch (10).

12. Justiervorrichtung nach Anspruch 1 mit einer Einrichtung zur ortsfesten Positionierung der Aufnahme (14) auf dem Tisch (10).

13. Justiervorrichtung nach Anspruch 12, bei der die Einrichtung eine Einrichtung zum Festsaugen der Aufnahme (14) auf dem Tisch (10) ist.

14. Justiervorrichtung nach Anspruch 1 mit Mitteln zur lösbaren Fixierung des zu positionierenden Gegenstandes (16) auf oder in der Aufnahme (14).

15. Justiervorrichtung nach Anspruch 14, wobei die Mittel eine Saugeinheit zur Festlegung des Gegenstandes (16) auf oder in der Aufnahme (14) mittels Unterdruck umfassen.

16. Justiervorrichtung nach Anspruch 1, bei der Gleitmittel zwischen Tisch (10) und Aufnahme (14) angeordnet sind.

## Claims

1. Adjusting device for aligning an object (16) in a plane, having the following features:
1.1 a table (10),
1.2 a receptacle (14) positionable on the table (10),
1.3 the receptacle (14) being designed for releasable fixing of the object (16) to be positioned,
1.4 at least three cables (20a-d), which are each articulated, via articulations (18a-d, 18aa, 18bb) which are arranged between the first ends of the cables (20a-d) and the receptacle (14) and which are pivotable along a plane parallel to the table (10), at a first end to opposite sections (14e, f) of the receptacle (14) and at a second end to table (10),
1.5 the cables (20a-d) acting in at least two different directions (x, y, α).

2. Adjusting device according to Claim 1, wherein the cables (20a-d) are arranged on the receptacle (14) in an articulated (18a-d) but stationary manner.

3. Adjusting device according to Claim 1, wherein the cables (20a-d) are guided between their ends over deflection rollers (22a-d).

4. Adjusting device according to Claim 1, wherein the first ends of the cables (20a-d) are arranged in the circumferential region of the receptacle (14)..

5. Adjusting device according to Claim 1, wherein the first ends of the cables (20a-d) have a maximum distance from one another.

6. Adjusting device according to Claim 1 having three cables, imaginary connecting lines between their first ends describing a triangle.

7. Adjusting device according to Claim 1 having four cables (20a-d), imaginary connecting lines between their first ends describing a rectangle.

8. Adjusting device according to Claim 7, wherein two cables (20a, b) each are arranged mirror symmetrically with respect to two further cables (20c, d).

9. Adjusting device according to Claim 7, the imaginary connecting lines describing a square.

10. Adjusting device according to Claim 1 having in each case a measuring device (32a, 34a) for determining the position of each first end of the cables (20a-d) and an evaluating unit (30) for determining the position of the receptacle (14) on the table (10).

11. Adjusting device according to Claim 1 having a measuring device for direct determination of the position of the receptacle (14) on the table (10).

12. Adjusting device according to Claim 1 having a device for stationary positioning of the receptacle (14) on the table (10).

13. Adjusting device according to Claim 12, wherein the device is a device for firmly sucking the receptacle (14) onto the table (10).

14. Adjusting device according to Claim 1 having means for releasable fixing, on or in the receptacle (14), of the object (16) to be positioned.

15. Adjusting device according to Claim 14, the means comprising a suction unit for fixing the object (16) on or in the receptacle (14) by means of negative pressure.

16. Adjusting device according to Claim 1, wherein sliding means are arranged between table (10) and receptacle (14).

## Revendications

1. Dispositif d'ajustage pour aligner un objet (16) dans un plan, avec les caractéristiques suivantes :
1.1 une table (10),
1.2 un logement (14) destiné à être positionné sur la table (10),
1.3 le logement (14) étant réalisé pour la fixation amovible de l'objet (16) à positionner,
1.4 au moins trois câbles (20a-d) qui, par l'intermédiaire d'articulations (18a-d, 18aa, 18bb) qui sont disposées entre les premières extrémités des câbles (20a-d) et le logement (14) et qui sont aptes à pivoter le long d'un plan parallèle à la table (10), sont articulés chacun avec une première extrémité contre des parties (14e, f) face à face du logement (14) et avec une deuxième extrémité contre la table (10),
1.5 les câbles (20a-d) agissant dans au moins deux directions différentes (x, y, α).

2. Dispositif d'ajustage selon la revendication 1, dans lequel les câbles (20a-d) sont agencés contre le logement (14) de manière articulée (18a-d), mais localement fixe.

3. Dispositif d'ajustage selon la revendication 1, dans lequel les câbles (20a-d), entre leurs extrémités, sont guidés autour de poulies de renvoi (22a-d).

4. Dispositif d'ajustage selon la revendication 1, dans lequel les premières extrémités des câbles (20a-d) sont situées dans la zone périphérique du logement (14).

5. Dispositif d'ajustage selon la revendication 1, dans lequel les premières extrémités des câbles (20a-d) sont situées à une distance maximale les unes des autres.

6. Dispositif d'ajustage selon la revendication 1 comportant trois câbles, dans lequel des lignes de liaison imaginaires décrivent un triangle entre leurs premières extrémités.

7. Dispositif d'ajustage selon la revendication 1 comportant quatre câbles (20a-d), dans lequel des lignes de liaison imaginaires décrivent un rectangle entre leurs premières extrémités.

8. Dispositif d'ajustage selon la revendication 7, dans lequel respectivement deux câbles (20a, b) sont disposés symétriquement à deux autres câbles (20c, d).

9. Dispositif d'ajustage selon la revendication 7, dans lequel les lignes de liaison imaginaires décrivent un carré.

10. Dispositif d'ajustage selon la revendication 1 comportant dans chaque cas un dispositif de mesure (32a, 34a), destiné à déterminer la position de chaque première extrémité des câbles (20a-d), et une unité d'analyse (30), destinée à déterminer la position du logement (14) sur la table (10).

11. Dispositif d'ajustage selon la revendication 1 comportant un dispositif de mesure pour déterminer directement la position du logement (14) sur la table (10).

12. Dispositif d'ajustage selon la revendication 1 comportant un dispositif pour positionner de manière localement fixe le logement (14) sur la table (10).

13. Dispositif d'ajustage selon la revendication 12, dans lequel le dispositif est un dispositif destiné à fixer par aspiration le logement (14) sur la table (10).

14. Dispositif d'ajustage selon la revendication 1 comportant des moyens pour la fixation amovible de l'objet (16) à positionner sur ou dans le logement (14).

15. Dispositif d'ajustage selon la revendication 14, dans lequel les moyens comportent une unité d'aspiration destinée à fixer l'objet (16) sur ou dans le logement (14) sous l'effet d'une dépression.

16. Dispositif d'ajustage selon la revendication 1, dans lequel des moyens de glissement sont disposés entre la table (10) et le logement (14).
